## Europäisches Patentamt

## European Patent Office

## Office européen des brevets

(19)

(11) Veröffentlichungsnummer: **0 091 067**
**B1**

(12) # EUROPÄISCHE PATENTSCHRIFT

(45) Veröffentlichungstag der Patentschrift:
**10.07.85**

(51) Int. Cl.⁴: **H 03 J 7/18, H 04 B 7/02**

(21) Anmeldenummer: **83103094.5**

(22) Anmeldetag: **29.03.83**

(54) Verfahren zum Umschalten der Wiedergabe eines Rundfunksignals auf ein anderes Rundfunksignal.

(30) Priorität: **05.04.82 DE 3212615**

(43) Veröffentlichungstag der Anmeldung:
**12.10.83 Patentblatt 83/41**

(45) Bekanntmachung des Hinweises auf die Patenterteilung:
**10.07.85 Patentblatt 85/28**

(84) Benannte Vertragsstaaten:
**DE FR GB IT SE**

(56) Entgegenhaltungen:
**DE - A - 1 466 242**
**DE - A - 1 591 144**
**DE - A - 2 724 068**
**GB - A - 2 007 945**

(73) Patentinhaber: **BAYERISCHE MOTOREN WERKE**
**Aktiengesellschaft, Postfach 40 02 40 Petuelring 130,**
**D-8000 München 40 (DE)**

(72) Erfinder: **Steins, Wilfried, Max-Hueber-Strasse 9,**
**D-8045 Ismaning (DE)**
Erfinder: **Welshaupt, Walter, Im Wismat 28,**
**D-8000 München 60 (DE)**

(74) Vertreter: **Bullwein, Fritz, Bayerische Motoren Werke**
**Aktiengesellschaft**
**Postfach 40 02 40 Petuelring 130 AJ-33,**
**D-8000 München 40 (DE)**

**Beschreibung**

Die Erfindung bezieht sich zum einen auf ein Verfahren zum Umschalten der Wiedergabe eines Rundfunksignals auf ein anderes Rundfunksignal gleichen Modulationsinhalts bei einem Kraftfahrzeug-Rundfunkempfänger. Ein derartiges Verfahren ist aus der DE-OS 1 591 144 bekannt.

Die Erfindung beschäftigt sich mit den Auswirkungen der beispielsweise durch unterschiedliche Standorte bewirkten Zeitverschiebung zweier Rundfunksignale gleichen Modulationsinhalts am Ort des Empfängers. Wird bei einer Störung des wiedergegebenen Rundfunksignals auf den Sender des anderen Rundfunksignals übergangslos umgeschaltet, so hat die Zeitverzögerung der beiden Rundfunksignale eine erhebliche Beeinträchtigung der Wiedergabequalität während des Umschaltvorgangs zur Folge. Die Umschaltung ist also, beispielsweise in Form eines Knackens, hörbar. Ursache dafür sind beispielsweise Gegenphasenlagen von Frequenzanteilen der beiden Rundfunksignale.

Für ein Nachrichtenübertragungssystem ist eine Raum- oder Frequenzdiversity-Schaltung bekannt, bei der sowohl von einem Empfänger auf den anderen als auch allmählich von zwei Empfängern auf nur einen Empfänger umgeschaltet wird, wenn der zunächst wiedergegebene Sender bzw. einer der zunächst wiedergegebenen Sender einen kleinen Geräuschabstand aufweist (vgl. DE-OS 1 466 242). Durch das allmähliche Umschalten sollen Knackgeräusche bei der Wiedergabe vermieden werden, die ihre Ursache in der Umschaltvorrichtung selbst haben.

Schließlich ist aus der GB-OS 2 007 945 eine Störunterdrückungseinrichtung für einen Schallplattenspieler bekannt, mit der die Wiedergabe während einer Störung unterbrochen wird und somit eine störungsfreie Wiedergabe erzielt wird.

Der Erfindung liegt die Aufgabe zugrunde, die Wiedergabequalität beim Umschalten von einem auf das andere Rundfunksignal zu verbessern.

Die Erfindung löst diese Aufgabe dadurch, daß bei Auftreten einer Störung des wiedergegebenen Rundfunksignals dieses in der Wiedergabeintensität allmählich ausgeblendet und das andere Rundfunksignal im gleichen Maße eingeblendet wird, wobei die Wiedergabe der Rundfunksignale gegenüber ihrem Empfang um eine vorgegebene Zeitdauer verzögert wird, die mindestens gleich der Dauer für die Überblendung von einem auf das andere Rundfunksignal ist.

Durch die allmähliche Überblendung vom zunächst wiedergegebenen Sender auf den anderen Sender lassen sich die die Wiedergabequalität beeinträchtigenden Faktoren weitgehend ausschalten. Durch die Ausblendung des zunächst wiedergegebenen Senders wird auch die Wiedergabe der aufgetretenen Störung verhindert und durch die Wiedergabe des störungsfreien anderen Rundfunksignals ersetzt.

Durch die Maßnahme, die Wiedergabe der Rundfunksignale gegenüber ihrem Empfang um eine vorgegebene Zeitdauer zu verzögern und während dieser Zeitdauer auf das nicht gestörte Rundfunksignal überzublenden, wird erreicht, daß der Überblendvorgang bei Ablauf der Verzögerungszeit bereits abgeschlossen ist. Die Wiedergabe erfolgt dann völlig störungsfrei. Im Gegensatz zu der aus der GB-OS 2 007 945 bekannten Einrichtung erfolgt sie darüber hinaus auch völlig lückenlos.

Die Erfindung beschäftigt sich zum anderen auch mit einer Schaltanordnung zur Durchführung des erfinderischen Verfahrens. Diese besteht aus Eimerkettenschaltungen, über die die Modulationssignale der beiden Sender geführt sind, aus einer vorgeschalteten Störerkennungsschaltung und aus einer nachgeschalteten Überblendeinrichtung an einem Rundfunksignal auf das andere. Dabei lassen sich z. B. übliche Störerkennungsschaltungen, die unter der Bezeichnung ASU bzw. EIC bekannt sind, verwenden.

In der Zeichnung ist ein Ausführungsbeispiel einer derartigen Schaltanordnung beschrieben sowie die wesentlichen Merkmale anhand eines Diagramms erläutert. Dabei zeigt

Fig. 1 den prinzipiellen Aufbau einer Schaltanordnung für ein Verfahren zur störungsfreien Wiedergabe eines Rundfunksignals und

Fig. 2 ein Diagramm zur Erläuterung der Funktionsweise des Verfahrens.

Eine beispielsweise im Autoradio eines Kraftfahrzeuges verwendete Schaltanordnung besteht im wesentlichen aus zwei parallelen Empfangs- und Wiedergabezweigen 1 bzw. 2 für zwei Rundfunksignale gleichen Modulationsinhalts. Diese Gleichheit wird beispielsweise in der im deutschen Patent 3 037 411 beschriebenen Weise ermittelt.

Jeder der Zweige 1 und 2 besteht aus einem Emfpangsteil 3 bzw. 4, einem ZF-Teil 5 bzw. 6, einem Stereodecoder 7 bzw. 8, einem Verstärkerteil 9 bzw. 10, Eimerkettenschaltungen 11 bzw. 12 sowie Filtern 13 bzw. 14. Zwischen den ZF-Teilen 5 bzw. 6 und dem nachgeschalteten Stereodecoder 7 bzw. 8 ist jeweils eine Störerkennungsschaltung 15 bzw. 16 angeschlossen, deren Ausgang wie zusätzliche Ausgänge 5' bzw. 6' der ZF-Teile 5 bzw. 6 und der Filter 13 bzw. 14 auf eine NF-Überblendeinrichtung 17 geschaltet sind. Diese liefert für jeden Stereokanal ein Eingangssignal für Endstufen 18, an denen Wiedergabe-Lautsprecher 19 bzw. 20 angeschlossen sind.

Die Eimerkettenschaltungen 11 bzw. 12 werden synchron durch einen Taktgeber 21 getaktet. Sie sind identisch aufgebaut und bestehen jeweils aus einer Vielzahl gleicher analoger Speicherelemente in Form von beispielsweise Feldeffekt-Transistoren. Sie bewirken eine Verzögerung der zu den Endstufen 18 gelangenden Rundfunksignale gegenüber ihrem Eingang in den Empfängern 3 bzw. 4. Die erreichte Verzögerungszeit ist dabei so bemessen, daß bei Auftreten einer Störung des gerade wiedergegebenen Rundfunksignals die mit Hilfe der Überblendeinrichtung 17 vorgenommene Umschaltung auf die Wiedergabe des anderen Rundfunksignals abgeschlossen ist, bevor diese Störung zur Wiedergabe gelangen würde.

Tritt eine Störung des Rundfunksingals bzw. der Senderfeldstärke auf, so steuert die Störerkennungsschaltung 15 bzw. 16 der ZF-Teile 5 bzw. 6 (Ausgänge 5' bzw. 6') des jeweils auf die Endstufen durchgeschalteten Zweigs 1 bzw. 2 die Überblendeinrichtung 17 an und veranlaßt diese, diesen Zweig allmählich auszublenden und dafür den anderen Zweig einzublenden. Diese Überblendung ist abgeschlossen, bevor die Störung die jeweilige Eimerkettenschaltung 11 bzw. 12 durchlaufen hat. Durch die allmähliche Überblendung mit Hilfe der Überblendeinrichtung 17 erfolgt die Umschaltung auf den anderen Zweig ohne Beeinträchtigung der Wiedergabequalität, da sich beispielsweise Gegenphasenlagen nicht hörbar auswirken können.

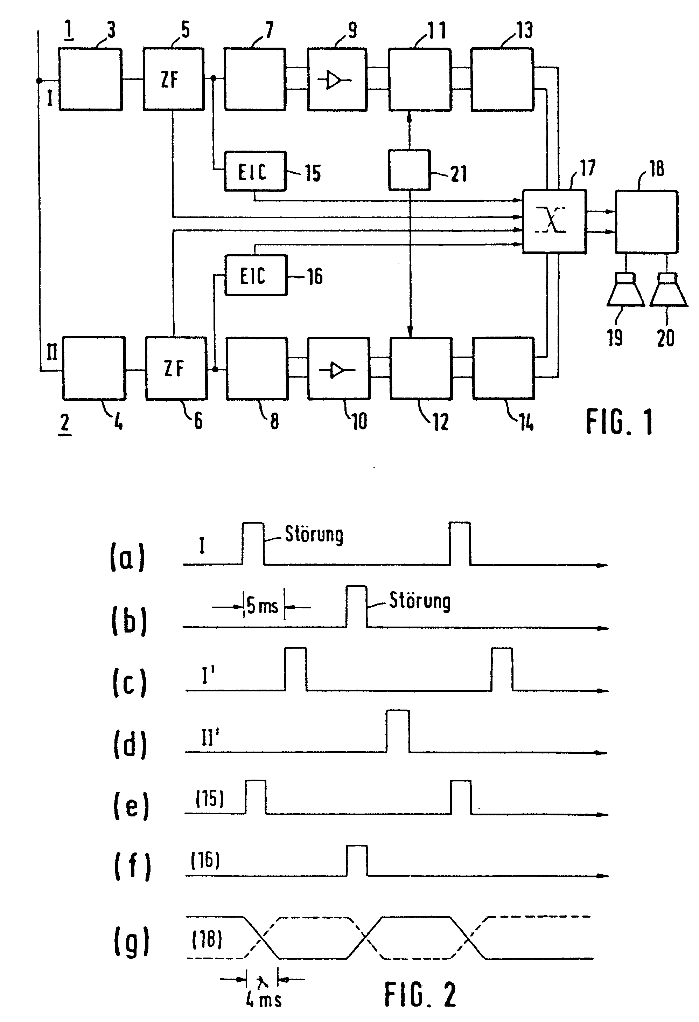

Anhand des Diagramms von Fig. 2 ist insbesondere die durch die Zeitverzögerung der Rundfunksignale bewirkte Störungsunterdrückung erläutert.

Teil a zeigt dabei zwei schematisch dargestellte Störungen im NF-Signal des mit Hilfe des Zweigs 1 wiedergegebenen Senders I. Teil b zeigt eine Störung des entsprechenden Rundfunksignals eines Senders II, das im Zweig 2 verarbeitet wird. Die Teile c und d zeigen die am Ausgang der Eimerkettenschaltungen 11 bzw. 12 anstehenden Signale der beiden Sender I und II. Die Teile e und f zeigen die durch die Störerkennungsschaltungen 15 bzw. 16 an die Überblendeinrichtung 17 gelieferten Ausgangssignale. Schließlich zeigt der Teil g die Wiedergabeintensität der Rundfunksignale der beiden Sender I und II. Dabei ist die des Senders I ununterbrochen und die des Senders II unterbrochen dargestellt.

Es soll zunächst das Eingangssignal des Senders I wiedergegeben werden. Dabei ist der Zweig 1 durchgeschaltet und steuert die Endstufen 18 an, während das Eingangssignal des Senders II nicht zur Wiedergabe gelangt. Hierzu ist das Ausgangssignal des Zweigs 2 durch die Überblendeinrichtung 17 blockiert. Tritt nun die im Teil a dargestellte Störung auf, so wird die Überblendeinrichtung 17 durch die Störerkennungsschaltung 15 aktiviert mit der Folge, daß nunmehr auf die Wiedergabe des Rundfunksignals im Kanal II übergeblendet wird. Dabei wird der Zweig 2 zu den Endstufen 18 allmählich durchgesteuert und der Zweig 1 in entsprechender Weise blockiert. Nach Ablauf einer vorgegebenen Zeit von z. B. 4 ms wird allein der Sender II wiedergegeben. Durch die mit Hilfe der Eimerkettenschaltung 11 bewirkte Verzögerung der Wiedergabe des NF-Signals des Senders I und damit auch der auftretenden Störung (Teil c des Diagramms) ist die Überblendung auf den Sender II bereits abgeschlossen, wenn die Störung am Ausgang der Eimerkettenschaltung 11 anliegt. Hierzu ist lediglich erforderlich, die Überblendung innerhalb der durch die Eimerkettenschaltungen bewirkten Verzögerung vorzunehmen. Die Verzögerungszeit ist beispielsweise gleich 5 ms gewählt.

Bei Auftreten der Störung im Sender II (Teil b des Diagramms) erfolgt die umgekehrte Überblendung auf den Sender I. Statt des Zweigs 2 wird nunmehr wieder der Sender I zu den Endstufen 18 durchgesteuert. Auch die Störung des Senders II gelangt, bedingt durch die Wirkung der Eimerkettenschaltung 12, nicht zur Wirkung, da vor ihrem Auftreten am Ausgang der Eimerkettenschaltung 12 und damit am Eingang der Überblendeinrichtung 17 der Zweig 2 blockiert ist.

Schließlich führt die erneute Störung im Kanal I zur Überblendung auf die Wiedergabe des Rundfunksignals von Kanal II noch bevor diese Störung wiedergegeben werden könnte.

## Patentansprüche

1. Verfahren zum Umschalten der Wiedergabe eines Rundfunksignals auf ein anderes Rundfunksignal gleichen Modulationsinhalts bei einem Kraftfahrzeug-Rundfunkempfänger, dadurch gekennzeichnet, daß bei Auftreten einer Störung des wiedergegebenen Rundfunksignals dieses in der Wiedergabeintensität allmählich ausgeblendet und das andere Rundfunksignal im gleichen Maße eingeblendet wird, wobei die Wiedergabe der Rundfunksignale gegenüber ihrem Empfang um eine vorgegebene Zeitdauer verzögert wird, die mindestens gleich der Dauer für die Überblendung von einem auf das andere Rundfunksignal ist.

2. Schaltungsanordnung zur Durchführung des Verfahrens nach Anspruch 1, gekennzeichnet durch Eimerkettenschaltungen (11 bzw. 12), über die die Rundfunksignale geführt sind, durch eine vorgeschaltete Störerkennungsschaltung (15 bzw. 16) und durch eine nachgeschaltete Überblendeinrichtung (17) vom einen Rundfunksignal auf das andere Rundfunksignal (I bzw. II).

## Claims

1. A method of switching the reproduction of a radio signal to another radio signal having the same modulation content in a radio receiver in a motor vehicle, characterized in that, when interference with the reproduced radio signal occurs, this signal is gradually faded out and the other radio signal is faded in to the same extent, reproduction of the radio signals being delayed in relation to their reception by a prescribed period which is at least equal to the duration required for fading from one radio signal to the other.

2. A circuit arrangement for carrying out the method of claim 1, characterized by: bucket-chain circuits (11; 12), through which the radio signals are passed; by an upstream interference-recognition circuit (15; 16); and by a downstream device (17) for fading from one radio signal to the other (I; II).

## Revendications

1. Procédé pour commuter la reproduction d'un signal radio sur un autre signal radio de même contenu de modulation, dans le cas d'un récepteur radio de véhicules automobiles, procédé caractérisé en ce que, lorsqu'intervient une perturbation du signal radio reproduit, celui-ci est progressivement supprimé dans l'intensité de reproduction, tandis que l'autre signal radio est superposé dans la même mesure, la reproduction des signaux radio par rapport à leur réception étant retardée d'un laps de temps prédéfini qui est au moins égal à la durée de l'enchaînement d'un signal radio à l'autre.

2. Dispositif de branchement pour la mise en oeuvre du procédé selon la revendication 1, caractérisé par des circuits à transfert de charge (11 ou bien 12), par l'intermédiaire desquels les signaux radio passent par l'intermédiaire d'un circuit de détection des perturbations branchées en amont (15 ou bien 16) et par l'intermédiaire d'un dispositif d'enchaînement branché à la suite (17) d'un signal radio à l'autre signal radio (I ou bien II).

FIG. 1

FIG. 2